# EUROPEAN PATENT SPECIFICATION

(11) **EP 2 070 014 B1**
(45) Date of publication and mention of the grant of the patent: **25.05.2016**
(21) Application number: 07875200.3
(22) Date of filing: 26.09.2007
(51) Int. Cl.: G06K 19/07, G06K 19/077, H01L 23/48, H01F 41/04, H01L 23/488

(54) **METHOD AND APPARATUS FOR MAKING A RADIO FREQUENCY INLAY**
VERFAHREN UND VORRICHTUNG ZUR HERSTELLUNG EINES HF-INLAYS
PROCÉDÉ ET APPAREIL PERMETTANT DE CRÉER UNE INCRUSTATION DE RADIOFRÉQUENCE

(30) Priority: 26.09.2006 US 826923 P; 17.10.2006 US 829862 P; 10.04.2007 US 733756
(43) Date of publication of application: 17.06.2009
(73) Proprietor: HID Global GmbH, 65396 Walluf (DE)
(72) Inventor: FINN, David, Tourmakeady Co. Mayo (IE)
(74) Representative: Grosfillier, Philippe
(86) International application number: PCT/IB2007/004658
(87) International publication number: WO 2009/030979

(56) References cited:
- DE-A1- 19 840 220
- DE-A1-102004 011 929
- DE-A1-102004 045 896
- US-A1- 2001 054 230

## Description

### FIELD OF THE INVENTION

The present invention relates to a method and apparatus for making radio frequency (RF) inlays and the resulting inlay, and more particularly to a method and apparatus for making high frequency RF devices that include an integrated circuit and an antenna affixed to a substrate material.

### BACKGROUND OF THE INVENTION

An RF inlay is generally understood to be an integrated circuit and antenna joined together on some type of substrate. Typically, the inlay is subjected to further processing to make a final product. Further processing may include adding additional outer layers of material such as plastic to make a card-shaped device. Other finishing techniques may form the inlay into a variety of final forms depending upon the final application of the product.

In general terms, the integrated circuit is inductively coupled to one or more interrogating devices or readers through the antenna by means of radio frequency communication. The integrated circuit or chip contains information that is useful for performing various tasks. One type of information is identification information pertaining to the holder or user of the RF device. In this case, the RF device may also be referred to as a radio frequency identification (RFID) device. Not all RF devices necessarily contain information about the identity of the user and some RF devices contain information in addition to the identity of the user.

RF inlays in their finished form are used in a variety of applications. For example, RF inlays are used for making security access devices (RFID devices) or may be used for other applications that may or may not involve identification of the user, including but not limited to access to computer or computer networks and databases, public transportation passes, toll way access passes, vending machine payment devices, debit and/or credit cards and passports. Given the variety and expanding end user applications for RF devices, they are also sometimes referred to as "smart cards." Some identification applications, such as passports, now utilize RFID inlays or RFID prelams (transponders that have been subjected to a lamination process) to store identification data and to allow efficient and rapid transfer of the identification data for processing by appropriate governmental agencies. The identification data may include biometric data, such as fingerprints, and/or photos of the passport holder, as well as information identifying the holder.

A variety of methods exist for manufacturing RF inlays. In some methods a substrate of one or more layers is processed in various steps including hot and/or cold lamination. A chip and antenna subassembly is incorporated in one or more of the layers and the layers are joined together by adhesives or by softening the plastic layer and, by means of pressure, joining the layers together. In other methods, wire is affixed to or embedded within a substrate in the form of an antenna and the opposing ends of the antenna coil are attached to the terminals of an integrated circuit (IC or chip) or to the terminal areas of a chip module. A chip module as that term is used herein comprises an integrated circuit attached to a lead frame having enlarged terminal areas. The terminal areas of the chip are connected to the enlarged terminal areas of the lead frame by either extremely small and delicate wires, on the order of 20 to 28 microns in diameter, or through a conductive adhesive such as in the case of a flip chip. The chip and the electrical connections to the terminal areas of the lead frame are encased in an epoxy layer for protection. The combination or subassembly of the chip/chip module and the coil of wire that forms an antenna is sometimes referred to as a transponder. The wire forming the antenna may be embedded fully or partially within the substrate by use of an ultrasonic wire embedding technique, as understood by those skilled in the art. The chip/chip module may be secured to the substrate by either placing it on the surface of the substrate or by placing it in a recess formed in the substrate. Adhesive may or may not be used to adhere the chip/chip module to the substrate. The ends of the coil of wire may be bonded or connected to the terminal areas of the chip or chip module at about the same time as the wire is embedded in the substrate, or the bonding may be done in a separate or subsequent manufacturing step.

Nominally, the wire used in the manufacture of RF inlays, where the wire is ultrasonically embedded in a substrate, is 110 to 120 microns in diameter, which includes an outer insulating layer. The wire is insulated to prevent short-circuiting of the antenna, as the windings of wire forming the antenna are closely positioned and may touch. The insulation layer is typically made from polyurethanes, polyvinylbutyrals, polyamides, polyesterimids and similar compounds. Thicker or larger diameter wires, compared to thinner or smaller diameter wires, are more easily handled and typically provide a farther read range when inductively coupled to a reader. Larger diameter wires are also more robust and are susceptible to removal from an RF device without damage to the operation and functionality of the transponder. Potential removal and reuse of a transponder raises a number of security and privacy problems. For example, if a legitimate transponder subassembly (chip/chip module and antenna) may be removed from one passport and placed in another fraudulent passport, substantial security issues are raised.

There are a number of patents that disclose various devices and methods for the manufacture of RF devices including the manufacture of inlays. For example, U.S. Patent Nos. 6,698,089 and 6,233,818 disclose methods of making an RF device wherein at least one chip and one antenna are affixed to a chip mounting board or substrate. The wire forming the antenna is embedded in the substrate by use of an ultrasonic generator. As part of the wire embedding process disclosed in each of these patents, the insulated antenna wire is first fixed to the substrate. The insulated wire is then guided directly over and away from a terminal area of the RFID chip and embedded to the substrate on the opposite side of the chip from the first embedding location to linearly align the wire between the two fixed locations and directly across the terminal area. Next, the antenna is formed by embedding the insulated wire into the substrate at a location spaced from the chip and terminal areas, the antenna being formed with a specific number of turns or loops of the wire. The antenna wire is then guided over another terminal area of the RFID chip and finally embedded on the opposite side to anchor the second end of the wire directly across the other terminal area of the chip. The wire is cut and the embedding head (or embedding tool) moves to a second transponder site on the substrate to repeat the same process. In the next stage of production, the wire portions passing directly over the terminal areas of the RFID chip are interconnected to the terminal areas by means of thermal compression bonding. Alternatively, the wire may be embedded as described and the chip subsequently positioned in a pre-designated recess where the terminals of the chip will contact the previously secured wire. The ends of the wire then will be bonded to the terminal areas of the chip by means of thermal compression bonding. U.S. Patent 6,088,230 describes an alternative process where a first end of the wire is positioned in contact with a first terminal area of a chip or chip module and is bonded to the first terminal area, then the embedding tool embeds the wire in the substrate to form an antenna, and then the wire is positioned over a second terminal area of the chip or chip module where it is bonded to the terminal area.

While the inventions disclosed in these references may be adequate for the intended purposes, there is still a need for an improved method of making RF inlays for various applications including but not limited to contactless smart cards and other security access devices.

Document DE 10 2204 045 896 A1 discloses a transponder having antenna wires on a substrate with laterally offset connection to flip chip modules using contact surfaces on a connection bridge substrate. The method of this prior art includes the steps of embedding a wire in the substrate to form an antenna, inserting the bridge underneath the ends of the wire, connecting the wire ends to the contact surfaces and applying a chip module.

DE19840220A1 discloses a method for producing a transponder module initially comprising the step in which a metallization layer is deposited on a first auxiliary support. Afterwards, a circuit chip comprising a first connecting area located on a first main surface of the same and comprising a second connecting area located on a second main surface of the same which is opposite the first main surface is deposited on the metallization layer in such a way that the second connecting area is conductively connected to the metallization layer. Next, an insulation layer is produced on the metallization layer such that the circuit chip is surrounded by the insulation layer, and the surface of the insulation layer facing away from the metallization layer is flush with the first surface of the circuit chip facing away from the metallization layer. A structured metallization with a first and second connection end, said connection end defining an antenna device, is produced on the insulation layer and on the circuit chip such that the first connection end is connected to the first connecting area of the circuit chip, whereupon a plated-through contact is produced which passes through said insulation layer in order to conductively connect the second connection end of the structured metallization to the metallization layer. Finally, the first auxiliary support is removed.

### SUMMARY OF THE INVENTION

In accordance with the present invention, a method according to claim 1 is provided for manufacturing RF inlays. In a further aspect, the present invention concerns the resulting inlay device produced by the method according to claim 1.

In accordance with the apparatus for making the inlays, one or more wire embedding heads, or sonotrodes as they may also be called, are used to embed antenna wire partially or fully into a substrate. The embedding heads may form the wire into virtually any pattern including forming the windings of an antenna. The substrate may accommodate one or a plurality of antennas. A single antenna may correspond to a single inlay or two or more antennas may be positioned in close proximity to each other and correspond to a single inlay. In the latter case, the plurality of antennas may be connected to a common chip/chip module or to different chips/chip modules and function independently. If a plurality of embedding heads is utilized, the embedding heads may move in unison or independently. Upon completion of the wire embedding at each transponder site, the wire is cut and either the embedding head(s) move to the next site or the substrate moves relative to the embedding head(s) to position new transponder sites proximate the embedding heads. Typically, the chip or chip module is placed on the substrate or in a recess formed in the substrate prior to any wire being embedded into the substrate. However, in the present invention, the chip/chip module may be placed in position after or during the wire embedding process.

The present invention provides an alternative approach of embedding wire into a substrate as described in the previously identified prior art patents and other known prior art. Rather than embedding the wire on one side of the terminal area of the RFID chip or chip module, guiding the wire directly over the terminal area, then embedding the insulated wire into the substrate on the opposite side of the terminal area, forming the antenna and then positioning the insulated wire directly over a second terminal area of the RFID chip and embedding it again, it is proposed that the embedding and bonding process begin with the wire adjacent to and laterally offset from the terminal area of a chip or chip module and that the wire not be passed over the terminal area. Rather, the wire is embedded into the substrate to form an antenna with the two end portions of the wire forming the antenna, not embedded in the substrate. The two end portions are positioned adjacent to and laterally offset from terminal areas of a chip or chip module. In one embodiment the full length of each of these end portions of wire are unsecured to the substrate. In a second step, after the antenna is formed, the end portions of the wire are moved into a position over or in contact with the terminal areas of the chip or chip module. The wire ends are not brought into contact with the terminal areas until after the antenna is fully formed, and bonding does not occur until the antenna is fully formed. In a second embodiment of the invention, a first length of the wire is embedded in the substrate with the beginning portion of the first length of wire extending out of the substrate. This first length of wire is positioned adjacent to and laterally offset from a terminal area of a chip or chip module. A next continuous length of wire is not embedded in the substrate but is placed over the substrate. The next following length of wire is embedded into the substrate to form an antenna. Then, the next continuous length is positioned along the substrate but not embedded. Finally, a length of wire is embedded in the substrate with the final portion of that length of wire extending out of the substrate. The last two lengths of wire are positioned adjacent to and laterally offset from the terminal areas of a chip or chip module. The lengths of wire that are laterally offset from the terminal areas are then repositioned so that portions of those lengths of wire are positioned over or in contact with the terminal areas of the chip or chip module. These lengths of wire are not brought into contact with the terminal areas until after the antenna is fully formed.

In yet a further processing step in accordance with the method and apparatus of the present invention, a bonding element is provided that electrically connects the lengths of wire positioned over or in contact with the terminal areas to the designated terminal areas. Bonding does not occur until the antenna is fully formed.

It should be appreciated that these processing steps may all occur at a single location or may occur at multiple locations. For example, a single head element may include the ultrasonic embedding tools, the tool to reposition the lengths of wire over or in contact with the terminal areas, and the bonding tool. Alternatively, these tools may be positioned on two or more separate heads or each positioned on a separate tool head. Still further, the substrate may be moved to different positions for some or all of these process steps while the tools remain stationary.

Various other features and advantages will become apparent from a review of the following detailed description taken in conjunction with the drawings.

### BRIEF DESCRIPTION OF THE DRAWINGS

Fig. 1 is a schematic view of an embedding tool such as a sonotrode having a length of residual wire extending from the end of the capillary tube having been previously cut following completion of wire placement in an RF device;
Fig. 2 is a schematic view of the embedding tool in a raised position wherein an additional length of wire is dispensed from the tool compared to that of Fig. 2;
Fig. 3 is a fragmentary perspective view of a processing machine used to manufacture RF and/or RFID inlays;
Fig. 4 is an enlarged plan view of a portion of an RF or RFID inlay specifically illustrating a chip module positioned on a substrate, and placement of opposing ends of the antenna coil adjacent the chip module;
Fig. 5 is a partial perspective view of a portion of an RF or RFID inlay wherein the opposing ends of the antenna coil placed adjacent the chip module are formed as angular extensions from the coil and offset or spaced from the terminal areas;
Fig. 6 illustrates the embodiment of Fig. 5 with the angular extensions positioned over the terminal areas by brushing or combing them over the terminal areas so that the extensions may then be thermally bonded to the terminal areas;
Fig. 7 is a top plan view of a portion of a second embodiment of an RF or RFID inlay where portions of the opposing ends of the antenna wire are embedded in the substrate;
Fig. 8 is a cross-sectional view taken along line 8-8 of Fig. 7.
Fig 9 is a top plan view of a portion of an RF or RFID inlay illustrating a chip module positioned on a substrate, and the opposing ends of the antenna coil repositioned in contact with terminal areas of the chip module.
Fig. 10 is a side view of a thermal compression bonding element positioned over the end of a wire, which is positioned on a terminal area.

It should be appreciated that even though a chip module may be shown in the figures or described in the specification or claims, it is intended that a chip may be substituted for a chip module (or vice versa) without departing from the scope of the present invention.

### DETAILED DESCRIPTION

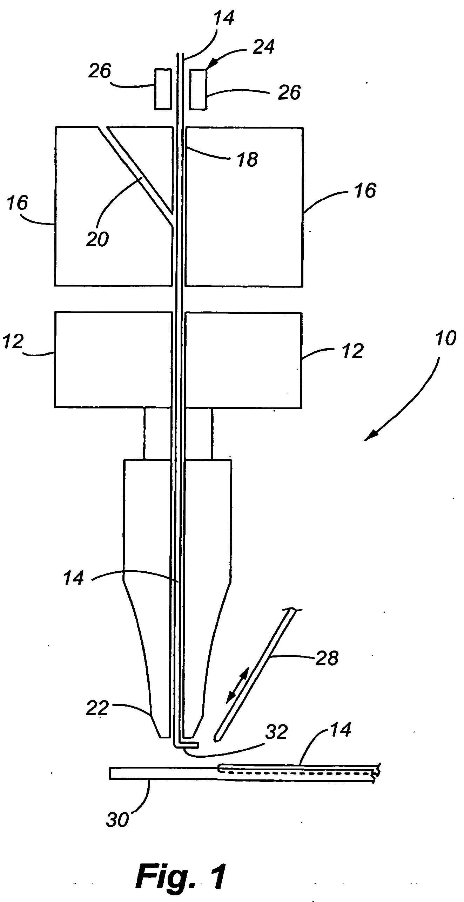

Fig. 1 illustrates an example of an embedding device 10 such as an ultrasonic sonotrode. The sonotrode includes an ultrasonic transducer 12 that locally heats a wire 14 through ultrasonic vibration. The embedding tool further includes a manifold 16 which houses a capillary tube 18 and a compressed air channel 20 that communicates with the capillary tube 18. The wire 14 is routed through the capillary tube 18 so that it can be dispensed from the distal tip 22 of the sonotrode. A wire clamping mechanism 24 comprises one method to control the feed of wire. The clamping mechanism jaws 26 close together to prevent feed of the wire. The compressed air may control the rate at which the wire is dispensed from the capillary tube when the jaws are open.

As also shown in Fig. 1, a knife 28 may form a part of the overall apparatus 10 and reciprocate between an upper and lower position to cut the wire 18 as needed, such as at the completion of a wire embedding step. As shown, a length of wire is embedded partially in the substrate 30 and a residual amount of wire 32 extends from the distal tip 22 of the embedding tool 10 following the cutting operation. This residual amount 32 is typically equal to the distance between the distal tip of the embedding tool and the knife or cutting tool 28. If the knife 28 is positioned relative to the embedding tool 10, the residual length may vary.

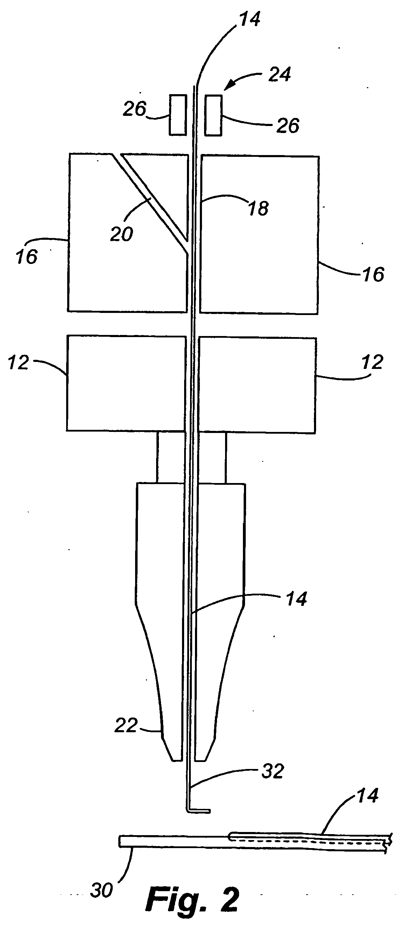

Referring to Fig. 2, the embedding tool 10 is shown in a raised position relative to the substrate 30. A greater length of residual wire 32 is shown compared to that shown in Fig. 1. In addition to being able to change the position of the knife relative to the embedding tool, another way to achieve the additional length in the residual wire is by forcing air through channel 20 to push a length of wire out of the sonotrode. Alternatively, it is possible to lengthen the residual length of wire by moving the embedding tool away from a location where the wire is embedded in or otherwise fixed to the substrate. If the wire is fixed to the substrate and the clamping mechanism 24 is open, an additional length of wire will be drawn from the wire supply as the embedding head is moved. In any case, the residual length 32 of the wire 14 will be increased.

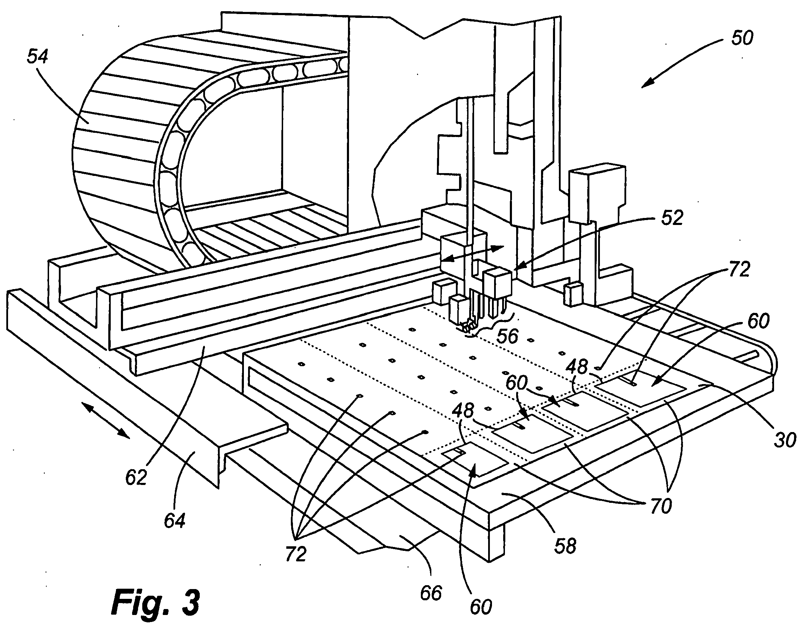

Fig. 3 illustrates one embodiment of a processing apparatus or machine 50 for manufacturing RF and/or RFID inlays. The machine 50 may be generally described as including a power drive group 52, a flexible communications bus 54 that transfers operational instructions from a computer processor (not shown) and power to the working components of the machine. For example, the bus 54 may facilitate the transfer of electronic signals between the processor and the working elements 56 of the machine that creates the inlays. As discussed further below, the working elements 56 may include a group or combination of one or more embedding tools, wire transfer tools, wire cutting tools and thermal bonding heads. Alternatively, the individual tools may be independently positionable relative to the substrate. The working elements 56 traverse laterally across a support table 58 that secures a substrate 30 affixing the wire to the substrate and, in some embodiments, moving the wire to a position over or in contact with terminal areas, and perhaps bonding the wire to the terminal areas. In the example machine shown in Fig. 3, a lateral slide rail 62 allows the working elements 56 to traverse in the lateral direction across the substrate 30. A longitudinal frame 64 secured to the lateral side rail 62 allows the machine to traverse or index in the longitudinal direction along longitudinal side rails 66. The dashed or phantom lines 68 designate or outline the prospective zones 70 where individual inlays are formed on the common substrate 30. Reference number 72 is a chip or chip module previously placed on the substrate, or designates a recess where a chip or chip module may be placed in the future. As mentioned, each inlay 60 has at least one transponder comprising an integrated circuit chip or chip module 72 and a wire antenna 48 that is connected to the chip or chip module 72. A CNC or similar controller controls the positioning and movement of the working elements 56 relative to the substrate 30.

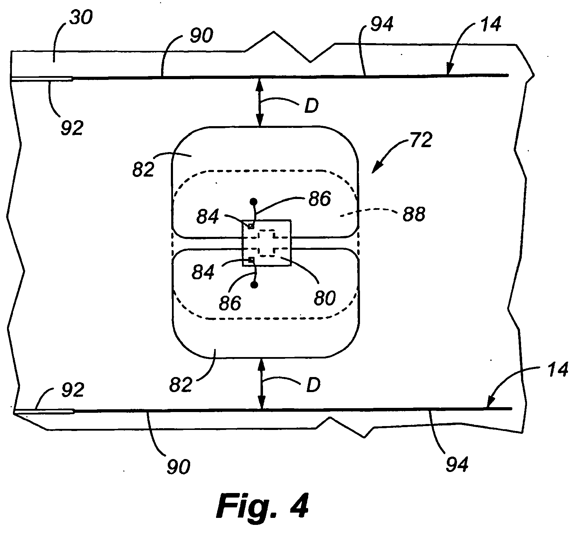

Referring to Fig. 4, a portion of an RF or RFID inlay device (hereinafter "device") is illustrated. In accordance with the present invention, the device includes the substrate 30, typically made of a thermoplastic material or other material receptive to wire embedding (or may comprise a layer of material receptive to wire bonding, such as an adhesive layer, affixed to the surface of another layer of material substrate, a chip module 72, and an antenna element (not fully shown) formed by a continuous length of wire 14. The chip module 72 in a known construction includes an integrated circuit 80 and at least one pair of terminal pads or terminal areas 82. Contacts or terminal areas 84 formed on the integrated circuit 72 are electrically connected to the terminal areas 82 by means of one or more very small leads or conductors 86. A protective layer of material such as epoxy 88 (shown in phantom lines to differentiate it from the other elements) covers the integrated circuit 80, portions of the respective terminal areas 82, the interconnecting conductors 86 and contacts 84. Alternatively, the chip module may be constructed and assembled in other ways known to those of skill in the art or the integrated circuit 80, alone, may be used in place of a chip module 72, in which case the antenna wire 14 is directly bonded to the contacts or bonding pads 86.

The portions of the wire 14 shown in Fig. 4 labeled by reference number 90 are the opposing ends of the wire that form the antenna. For illustrative purposes, the portion of the wire 14 represented by a hollow line segment 92 depicts an embedded portion of the wire, while the solid line segment 94 represents a non-embedded portion. As shown, there also is a distinct lateral offset or gap, represented by distance D, between the end portion 90 of the wire 14 and terminal area 82 illustrating that the wire is not guided or positioned over or in contact with the terminal area 82 as it is positioned on or affixed to the substrate 30. In the preferred embodiment, only after the wire 14 is completely affixed to the substrate to form an antenna are the end portions 90 displaced for purposes of bonding a portion of the wires to the terminal areas 82 or 84.

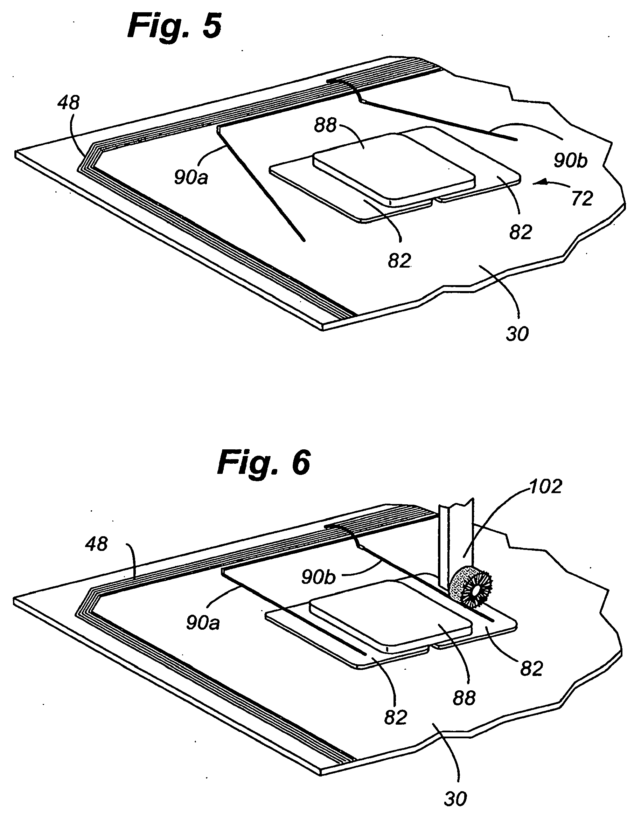

Referring now to Fig. 5, a partially completed inlay is shown. The ends of the wire 90 are arranged as extensions from the embedded coil and they do not contact any part of the chip module 72. Rather, the ends or extensions 90 are positioned on the substrate 30 laterally offset from the chip module. Whether all, some portion or none of the ends 90 physically touch the substrate is unimportant. It should be appreciated that the technique used to position the initial length of wire 90a shown on the substrate 30, prior to formation of the antenna may differ from the technique used to position the end or second length of wire 90b. In forming the initial length 90a, no portion of the wire 14 is affixed to the substrate. Therefore, the act of moving the embedding head 10, alone, will not cause wire to be drawn or expelled from the tool 10. Accordingly, use of the compressed air supply, or other means known to those of skill in the art, would be needed to expel the desired length of wire from the embedding head. This is accomplished by forcing compressed air, or another appropriate gas, through channel 20 while the clamp mechanism 24 is open. Positioning the desired length of wire on the substrate may be accomplished by movement of the embedding head. Alternatively, because the embedding head is repeatedly used to form successive inlays, it is also possible to draw a desired length of wire from the embedding head sufficient to form initial length 90a prior to cutting the wire following formation of end portion 90b of the previously formed inlay. Once the initial length of wire 90a has been arranged on the substrate, the antenna 48 is formed by embedding the wire in the substrate. Following formation of the antenna, another length of the wire 90b is positioned generally as shown to form the second angular extension. The end 90b may be formed by forcing wire out of the embedding head using compressed air or, because the antenna has been formed and the wire is embedded in the substrate, the second end 90b may be formed by moving the embedding head to draw wire out of the embedding head. Because the wire is fixed to the substrate, additional length of wire will be drawn out of the embedding head as it moves.

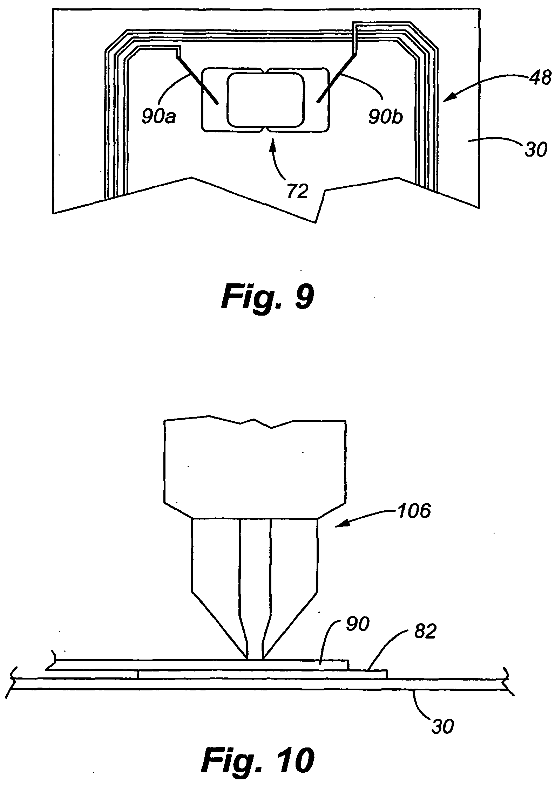

In the next step of the manufacturing process, an example of which is shown in Fig. 6, the extensions 90 are moved into position over or in contact with the terminal areas 82 for interconnection with the terminal areas 82. The extensions 90 may be mechanically moved into position, such as by a brush or comb or other mechanical instrument 102. One variety of brush is illustrated in Fig. 6. The mechanical positioner 102 may be another element incorporated in the group of working elements 56 on a single tool head, or it may be independently positionable. Alternatively, the extensions 90 may be manually gripped and moved into position. Again, the embedding tool does not traverse over any portion of the chip or chip module when positioning wire on the substrate. In the embodiment shown, the wire is cut at a position so that the extensions 90 are approximately the same length, and have approximately the same orientation with respect to the opposite sides of the terminal areas. However, it should be appreciated that the extensions 90 may have different lengths and/or orientations provided the relocation equipment can position the lengths of wire in contact with the terminal areas. Once the extensions are placed over the terminal areas, portions of the wire ends may be bonded to the terminal areas 82 using a thermal compression bonding element 106, as shown in Fig. 10. The bonding head 106 generates a voltage sufficient to electrically bond the wire to the terminal areas. The bonding head 106 is indexed or shifted from one bonding site to the next in order to sequentially bond each wire 90a and 90b to its corresponding terminal area.

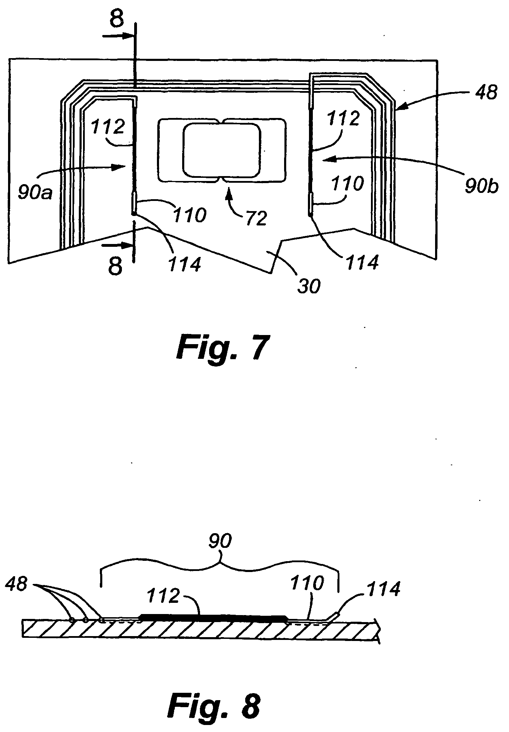

With reference to Figs. 7 and 8, in an alternative method, an initial portion 110 of the wire ends 90a is affixed to or embedded in the substrate for a relatively short distance, approximately 0.5 to 1.0 centimeters, although this length may vary. The ultrasonic transducer is then preferably turned off and the embedding head is moved relative to the substrate a distance from the first embedding location, thereby forming a non-unembedded portion 112. The ultrasonic transducer is turned on, and a further length of wire is embedded in the substrate, to form an antenna 48, for example. As a result of the actions of turning off the ultrasonic transducer and the continued movement of the embedding head, a portion of the wire 112 is not fixed to or embedded in the substrate. This length of wire is formed at a position laterally offset from the terminal areas of the chip or the chip module. The term laterally offset as used herein is defined generally relative to the plane of the substrate. Following completion of formation of the antenna 48 in the substrate, a second length of wire 90b is similarly formed and positioned at a second location on the substrate laterally offset from a second terminal of the chip or chip module. A portion 112 of the second length of wire 90b is not embedded into or affixed to the substrate. A final length of wire 110 is then embedded into the substrate. As shown, a tail portion 114, likely comprising the residual length of wire 32 illustrated in Fig. 1, is not embedded in the substrate, but extends out of the substrate. As with the first embodiment, the end portions 90a and 90b are formed at positions offset or spaced from the terminal areas and chip, and therefore no portion of the end portions 90 are positioned over or in contact with any portion of the chip 80 or terminal areas 82.

There are advantages of embedding a relatively small portion 110 of the ends 90. As a first matter, it positively locates or stabilizes the ends 90a and 90b in a known location. This facilitates subsequent movement of the ends 90a and 90b to a position over or in contact with the terminal areas 82 or 84, whether the movement is effectuated manually or mechanically. Also, it eliminates or reduces the need to use compressed air to force the wire out of the embedding tool when the first end portion 90a is formed. By embedding or anchoring a small portion 110 of the wire 14, the subsequent length of wire 112 may be pulled from the wire supply by movement of the embedding head. A s further alternative, applicable to both embodiments, an adhesive may be applied to the substrate at positions laterally offset from the terminal areas of the ship or ship module to temporarily hold and align the ends 90a and 90b at a desired location.

In a subsequent processing step of the type described in association with the first embodiment, the apparatus includes a wire-displacing tool that is used to reposition the lengths of wire 90a and 90b over or in contact with the terminal areas of the chip or chip module such that they may then be bonded to the designated terminal areas. Mechanical means may be provided to position the ends of wire 90a and 90b in contact with the terminal areas, such as by use of a brush or comb device as illustrated in Fig. 6. It is contemplated that the lengths of wire 110 that are embedded in the substrate are sufficiently short in length or the action of the mechanical element sufficiently robust that the action of the mechanical wire moving element can pull or remove the embedded lengths of wire 110 from the substrate 30 in order to reposition the wire as appropriate. If the ends are to be manually moved, either or both of the non-embedded portions 112 and 114 may be grasped by an individual, removed from the embedded state and moved into position.

While the foregoing invention has been disclosed with respect to preferred embodiments, it shall be understood that various other changes and modifications can be made to the invention in accordance with the scope of the claims appended hereto.

## Claims

1. A method of manufacturing a radio frequency inlay, said method comprising:
providing a substrate (30) defining a substrate plane, and an integrated circuit (80) positioned on said substrate or in a recess formed on said substrate, and a pair of terminal areas (82) associated with said integrated circuit;
affixing a wire (14) to said substrate, said affixing step including the steps of:
(i) positioning a first end portion (90a) of said wire on said substrate laterally offset from and not electrically connected to said terminal areas;
(ii) affixing a portion (48) of the wire to the substrate to form the windings of an antenna;
(iii) positioning a second end portion (90b) of said wire on said substrate laterally offset from and not electrically connected to said terminal areas;
(iv) repositioning the first end portion of said wire such that at least some of said first end position is positioned over or in contact with a first terminal area of the integrated circuit;
(v) repositioning the second end portion of said wire such that at least some portion of said second end portion is positioned over or in contact with a second terminal area of the integrated circuit and
(vi) electrically connecting said at least some of said first and second end portions of wire to the corresponding terminal areas.

2. A method as defined in claim 1, wherein, said positioning step of a first end portion further includes:
(i) at a position laterally offset from said terminal areas embedding a first portion (110) of said first end portion (90a) in said substrate.

3. A method as defined in claim 1 or 2, wherein, said positioning step of a second end portion further includes:
(ii) at a position laterally offset from said terminal areas forming a second portion (114) following said second end portion (90b) and embedding said second portion in said substrate.

4. A method as claimed in one of the preceding claims, wherein:
said first and second end portions are repositioned by a mechanical device (102).

5. A method, as claimed in claim 4, wherein:
said first end portion and said second end portion are moved by a brush or comb (102).

6. A method, as claimed in claim 3, wherein:
said repositioning steps (iv) and (v) remove end portions of wire from said substrate that had been previously embedded in said substrate.

7. A method, as claimed in claim 6, wherein said first portion of said first end portion and said second portion of said second end portion are removed from an embedded state as a result of displacing said first and second end portions.

## Patentansprüche

1. Verfahren zum Herstellen eines Hochfrequenz-Inlays, wobei das Verfahren die folgenden Schritte aufweist:
Bereitstellen eines Substrats (30), das eine Substratebene definiert, und einer integrierten Schaltung (80), die auf dem Substrat oder in einer auf dem Substrat ausgebildeten Aussparung angeordnet ist, und eines Paares von Anschlussflächen (82), die mit der integrierten Schaltung verbunden sind;
Befestigen eines Drahts (14) am Substrat, wobei der Befestigungsschritt die Schritte aufweist:
(i) Anordnen eines ersten Endabschnitts (90a) des Drahts auf dem Substrat seitlich versetzt von und nicht elektrisch verbunden mit den Anschlussflächen;
(ii) Befestigen eines Abschnitts (48) des Drahts am Substrat, um die Windungen einer Antenne zu bilden;
(iii) Anordnen eines zweiten Endabschnitts (90b) des Drahts auf dem Substrat seitlich versetzt von und nicht elektrisch verbunden mit den Anschlussflächen;
(iv) Neuanordnen des ersten Endabschnitts des Drahts, so dass mindestens ein gewisser Abschnitt der ersten Endposition über oder in Kontakt mit einer ersten Anschlussfläche der integrierten Schaltung angeordnet wird;
(v) Neuanordnen des zweiten Endabschnitts des Drahts, so dass mindestens ein gewisser Abschnitt des zweiten Endabschnitts über oder in Kontakt mit einer zweiten Anschlussfläche der integrierten Schaltung angeordnet wird und
(vi) elektrisches Verbinden des mindestens einen Abschnitts des ersten und zweiten Endabschnitts des Drahts mit den entsprechenden Anschlussflächen.

2. Verfahren nach Anspruch 1, wobei der Anordnungsschritt eines ersten Endabschnitts ferner aufweist:
(i) an einer von den Anschlussflächen seitlich versetzten Position Einbetten eines ersten Abschnitts (110) des ersten Endabschnitts (90a) in das Substrat.

3. Verfahren nach Anspruch 1 oder 2, wobei der Anordnungsschritt eines zweiten Endabschnitts ferner aufweist:
(ii) an einer seitlich von den Anschlussflächen versetzten Position Bilden eines zweiten Abschnitts (114) anschließend an den zweiten Endabschnitt (90b) und Einbetten des zweiten Abschnitts in das Substrat.

4. Verfahren nach einem der vorhergehenden Ansprüche, wobei:
der erste und zweite Endabschnitt durch eine mechanische Vorrichtung (102) neu angeordnet werden.

5. Verfahren nach Anspruch 4, wobei:
der erste Endabschnitt und der zweite Endabschnitt durch eine Bürste oder einen Kamm (102) bewegt werden.

6. Verfahren nach Anspruch 3, wobei:
die Neuanordnungsschritte (iv) und (v) Endabschnitte des Drahts vom Substrat entfernen, die vorher in das Substrat eingebettet worden sind.

7. Verfahren nach Anspruch 6, wobei der erste Abschnitt des ersten Endabschnitts und der zweite Abschnitt des zweiten Endabschnitts aus einem eingebetteten Zustand infolge des Verschiebens des ersten und zweiten Endabschnitts entfernt werden.

## Revendications

1. Procédé de fabrication d'un inlay radiofréquence, ledit procédé comprenant les étapes de:
fournir un substrat (30) définissant un plan de substrat, et un circuit intégré (80) positionné sur ledit substrat ou dans un renfoncement ménagé sur ledit substrat, et une paire de plages de connexion (82) associées audit circuit intégré ;
fixer un fil (14) audit substrat, ladite étape consistant à fixer comprenant les étapes de:
(i) positionner une première portion d'extrémité (90a) dudit fil sur ledit substrat en décalage latéral par rapport auxdites plages de connexion et sans la raccorder électriquement à celles-ci ;
(ii) fixer une portion (48) du fil au substrat pour former les enroulements d'une antenne ;
(iii) positionner une deuxième portion d'extrémité (90b) dudit fil sur ledit substrat en décalage latéral par rapport auxdites plages de connexion et sans la raccorder électriquement à celles-ci ;
(iv) repositionner la première portion d'extrémité dudit fil de manière à positionner une partie au moins de ladite première position d'extrémité pardessus une première plage de connexion du circuit intégré ou au contact de celle-ci ;
(v) repositionner la deuxième portion d'extrémité dudit fil de manière à positionner une partie au moins de ladite deuxième portion d'extrémité pardessus une deuxième plage de connexion du circuit intégré ou au contact de celle-ci et
(vi) raccorder électriquement ladite au moins une partie desdites première et deuxième portions d'extrémité du fil aux plages de connexion correspondantes.

2. Procédé selon la revendication 1, dans lequel ladite étape de positionner une première portion d'extrémité comprend en outre l'étape de:
(i) au niveau d'une position décalée latéralement par rapport auxdites plages de connexion, implanter une première portion (110) de ladite première portion d'extrémité (90a) dans ledit substrat.

3. Procédé selon la revendication 1 ou 2, dans lequel ladite de positionner une deuxième portion d'extrémité comprend en outre l'étape de:
(ii) au niveau d'une position décalée latéralement par rapport auxdites plages de connexion, former une deuxième portion (114) à la suite de ladite deuxième portion d'extrémité (90b) et implanter ladite deuxième portion dans ledit substrat.

4. Procédé selon l'une quelconque des revendications précédentes, dans lequel :
lesdites première et deuxième portions d'extrémité sont repositionnées au moyen d'un dispositif mécanique (102).

5. Procédé selon la revendication 4, dans lequel :
ladite première portion d'extrémité et ladite deuxième portion d'extrémité sont déplacées au moyen d'une brosse ou d'un peigne (102).

6. Procédé selon la revendication 3, dans lequel :
lesdites étapes (iv) et (v) de repositionnement retirent dudit substrat des portions d'extrémité du fil précédemment implantées dans ledit substrat.

7. Procédé selon la revendication 6, dans lequel ladite première portion de ladite première portion d'extrémité et ladite deuxième portion de ladite deuxième portion d'extrémité sont retirées d'un état implanté suite au déplacement desdites première et deuxième portions d'extrémité.
